# EUROPÄISCHE PATENTSCHRIFT

(11) **EP 1 319 965 B1**
(45) Veröffentlichungstag und Bekanntmachung des Hinweises auf die Patenterteilung: **26.04.2006**
(21) Anmeldenummer: 02023058.7
(22) Anmeldetag: 16.10.2002
(51) Int. Cl.: G01V 8/20, H03F 3/45, G01V 8/10

(54) **Auswerteschaltung und Signalverarbeitungsverfahren**
Evaluation circuit and signal processing method
Circuit d'évaluation et méthode de traitement de signal

(30) Priorität: 11.12.2001 DE 10160626
(43) Veröffentlichungstag der Anmeldung: 18.06.2003
(73) Patentinhaber: SICK AG, 79183 Waldkirch, Breisgau (DE)
(72) Erfinder: Blöhbaum, Frank, 79112 Freiburg (DE); Jahn, Axel, 79183 Waldkirch (DE)
(74) Vertreter: Manitz, Finsterwald & Partner GbR

(56) Entgegenhaltungen:
- DE-A- 3 543 666
- JP-A- 61 231 698
- US-A- 5 742 046
- US-A- 6 067 113

## Beschreibung

Die Erfindung betrifft eine Auswerteschaltung zur Verarbeitung eines differentiellen Empfangssignals eines optoelektronischen Sensors, insbesondere eines Lichtgitters, wenigstens mit einem Differenzverstärker zum Verstärken des Empfangssignals. Die Erfindung betrifft ferner ein entsprechendes Signalverarbeitungsverfahren.

In der Automatisierungs- und der Sicherheitstechnik ist der Einsatz von Lichtgittern bekannt, bei denen eine Vielzahl von parallelen Lichtstrahlen periodisch ausgesandt und überwacht wird, um eine flächige Überwachung durchzuführen. Das Empfangssignal jedes Lichtstrahls wird letztlich innerhalb einer einfachen Komparatorstufe mit einem Schwellenwert verglichen, um bei einem Unter- oder Überschreiten des Schwellenwerts ein Gegenstandsfeststellungs- oder ein Abschaltsignal auszulösen. Die empfangsseitige Signalverarbeitungskette enthält typischerweise für jeden Empfangskanal eine Fotodiode als Lichtempfänger, einen Transimpedanzverstärker mit Bandpasseigenschaft, eine Differenzverstärkerstufe und die genannte Komparatorstufe.

Im Hinblick auf die Vielzahl der Empfangskanäle ist eine möglichst kostengünstige Verwirklichung der Auswerteelektronik erwünscht. Es ist daher wünschenswert, die analoge Empfangssignalverarbeitung für jeden Empfangskanal zumindest teilweise in einem integrierten Schaltkreis zusammenzufassen, wobei diese Schaltkreise zu einem Analogbus parallel geschaltet werden. Dabei kann - zur weiteren Verringerung des Herstellungsaufwands - für alle Empfangskanäle dieses Analogbusses eine einzige gemeinsame Komparatorstufe vorgesehen sein.

Allerdings können diese integrierten Schaltkreise aufgrund von Fertigungsstreuungen vergleichsweise große Toleranzen aufweisen, so dass die differentielle Ausgangsstufe einen unerwünschten Offset, also eine unerwünschte Differenz der ausgegebenen Stromsignale bei kurzgeschlossenem Eingang aufweisen kann. Dieser Offset kann, insbesondere bei weiterer Verstärkung, dazu führen, dass bereits ohne Lichteinfall an dem zugeordneten Lichtempfänger der vorbestimmte Schwellenwert unbeabsichtigt überschritten wird und somit beispielsweise trotz Unterbrechung des betreffenden Lichtstrahls kein Abschaltsignal ausgelöst wird.

Diese Gefahr könnte zwar dadurch beseitigt werden, dass vor die Komparatorstufe ein Hochpass geschaltet wird. Allerdings erweist es sich als schwierig, eine Eckfrequenz für diesen Hochpass zu finden, die den Anforderungen des Gesamtsystems genügt. Eine zu niedrige Eckfrequenz kann nämlich dazu führen, dass bei einem Umschalten zwischen den verschiedenen Empfangskanälen die Variation des jeweiligen Offset ebenfalls bis zur Komparatorstufe durchgelassen wird und dort ein Schalten des Komparators bewirkt. Eine hohe Eckfrequenz des Hochpasses dagegen liegt zwangsläufig im Übertragungsbereich des Bandpasses des Empfangskanals bzw. des integrierten Schaltkreises. Auch dessen Bandpassgrenzen unterliegen zwangsläufig großen Schwankungen. Die Interaktion mit dem zwischengeschalteten Hochpass kann deshalb einen Bandpass höherer Ordnung mit nicht definierter Übertragungsfunktion ergeben, so dass die hieraus resultierenden Überschwinger im Zeitbereich wiederum ein unbeabsichtigtes Schalten der Komparatorstufe auslösen können.

Aus der EP 1 136 798 A1 ist eine Auswerteschaltung für einen Photodetektor bekannt, die zwei voll differentielle Verstärker und einen Nachverstärker mit einem unsymmetrischen Ausgangssignal besitzt. Die beiden Differenzverstärker sind mit Rücksetzschaltungen versehen, durch die die jeweiligen Ausgänge der Differenzverstärker auf ein Referenzpotential gesetzt werden können, um eventuelle Fluktuationen des aufintegrierten Signals zu stabilisieren. Ferner ist zwischen den beiden Differenzverstärkern eine Klemmschaltung vorgesehen. Durch diese Maßnahmen wird jedoch nicht sicher vermieden, dass im Nachverstärker ein eventueller Offset verstärkt wird.

Aus der US 5,998,779 ist es bekannt, zwischen einem Differenzverstärker und einem Nachverstärker eine Klemmschaltung anzuordnen, um Unterschiede hinsichtlich des Rauschens (fixed pattern noise) zwischen verschiedenen Chips zu verringern.

Aus der US 6 067 113 ist eine Auswerteschaltung zur Verarbeitung optischer Empfangssignale mit Vermeidung eines Offsets bekannt.

Es ist eine Aufgabe der Erfindung, bei kostengünstiger Herstellung die Detektionssicherheit noch weiter zu verbessern.

Diese Aufgabe wird durch eine Auswerteschaltung mit den Merkmalen des Anspruchs 1 gelöst.

Die Aufgabe wird ferner durch ein Signalverarbeitungsverfahren mit den Merkmalen des Anspruchs 9 gelöst.

Der Grundgedanke der Erfindung besteht also in der Verwendung einer Klemmschaltung zur Unterdrückung eines Offset an einer differentiellen Ausgangsstufe eines Empfangskanales eines optoelektronischen Sensors. Durch die Erfindung wird die Verwirklichung einer Vielzahl von Empfangskanälen innerhalb eines jeweiligen integrierten Schaltkreises begünstigt, da die bei einer Massenherstellung unvermeidbaren Kennzahltoleranzen nicht zu unerwünschten Fehldetektionen führen. Die erfindungsgemäße Auswerteschaltung und das erfindungsgemäße Signalverarbeitungsverfahren können somit selbst für eine Vielzahl von Empfangskanälen kostengünstig und ohne Beeinträchtigung der Zuverlässigkeit des Schwellenwertvergleichs realisiert werden.

Ein besonderer Vorteil der Erfindung besteht auch darin, dass das Schalten der differentiellen Ausgangsstufe auf das Referenzpotential bei elektronisch abgetrennter, aber dennoch aktivierter Eingangsstufe erfolgen kann; dies entspricht funktionell einer Fehlereliminierung bei "geschlossener Blende". Dadurch ist gewährleistet, dass die Klemmschaltung nicht auf eventuelle optische Störsignale geklemmt wird und damit Fehlfunktionen auslöst.

Ein weiterer Vorteil der Erfindung besteht darin, dass sie eine vergleichsweise hohe Taktrate hinsichtlich des Umschaltens bzw. sukzessiven Aktivierens der einzelnen Empfangskanäle ermöglicht. Zur Erzielung der erwünschten Detektionssicherheit ist nämlich nicht das Setzen von besonders engen koinzidenten Erwartungszeitfenstern und das hiermit verbundene Abwarten des Abklingens eines möglichen Offset mit einer vergleichsweise langen Zeitkonstanten erforderlich.

In einer bevorzugten Ausführungsform der Erfindung kann der wenigstens eine Ausgang des Differenzverstärkers durch Aktivieren und nachfolgendes Deaktivieren der Klemmschaltung für die Dauer eines bestimmten Zeitintervalls auf das Referenzpotential geschaltet werden. Durch das Deaktivieren der Klemmschaltung wird eine Beeinträchtigung der Übertragung des eigentlichen Nutzsignals des betreffenden Empfangssignals vermieden.

Weiterhin ist es für die Funktion der Unterdrückung eines Offsets bevorzugt, wenn zwei differentielle Ausgänge des Differenzverstärkers auf das Referenzpotential geklemmt werden können, und zwar insbesondere auf dasselbe Referenzpotential.

Hinsichtlich der Verwirklichung der Klemmschaltung ist es bevorzugt, wenn diese wenigstens einen elektronischen Schalter aufweist. Vorzugsweise sind zwei Schalter vorgesehen, die jeweils einem differentiellen Ausgang des Differenzverstärkers zugeordnet und bezüglich dieser Ausgänge im Wesentlichen symmetrisch angeordnet sind.

Ferner kann die Klemmschaltung wenigstens eine Speichereinrichtung aufweisen, durch die das Referenzpotential an dem oder den Ausgängen des Differenzverstärkers zumindest teilweise gespeichert werden kann. Vorzugsweise sind zwei derartige Speichereinrichtungen vorgesehen, die jeweils einem differentiellen Ausgang des Differenzverstärkers zugeordnet, bezüglich dieser Ausgänge im Wesentlichen symmetrisch angeordnet sowie im Wesentlichen gleich dimensioniert sind. In einer bevorzugten Ausführungsform werden die beiden Speichereinrichtungen - zumindest zeitweilig - auf ein gemeinsames Referenzpotential geschaltet.

Die genannte Speichereinrichtung ist vorzugsweise durch einen Speicherkondensator gebildet. Dieser Speicherkondensator kann innerhalb der Signalverarbeitungskette des betreffenden Empfangskanals seriell angeordnet sein, das heißt als Koppelkondensator fungieren.

Der Differenzverstärker kann ausgangsseitig - direkt oder indirekt, beispielsweise über die Klemmschaltung - mit einem Nachverstärker und/ oder mit dem bereits erwähnten Komparator verbunden sein. Außerdem kann die erfindungsgemäße Auswerteschaltung einen Empfänger - insbesondere eine Fotodiode - , einen nachgeordneten Transimpedanzverstärker, einen Bandpass und/oder eine Hintergrundlicht-Unterdrückungsschaltung besitzen.

In einer bevorzugten Ausführungsform der Erfindung besitzt die Auswerteschaltung eine Vielzahl von Empfangskanälen, beispielsweise wenigstens acht, insbesondere wenigstens hundert Empfangskanäle. Diese Empfangskanäle können - zumindest jeweils teilweise - zu einem Analogbus zusammengefasst sein, der mit einer gemeinsamen Ausgangsstufe aller Empfangskanäle verbunden ist.

Vorzugsweise können die Empfangskanäle - entsprechend einem Sendelicht-Pulstakt - nacheinander aktiviert werden, beispielsweise durch Aktivieren eines jeweils zugeordneten elektronischen Schalters oder durch Aktivieren einer jeweils zugeordneten Verstärkerstufe. Dabei können die Empfangssignale der Empfangskanäle jeweils nacheinander verarbeitet, insbesondere mit einem Schwellenwert verglichen werden.

Jeder Empfangskanal kann einen eigenen Differenzverstärker und insbesondere auch einen eigenen Lichtempfänger, einen eigenen Transimpedanzverstärker, einen eigenen Bandpass und/oder eine eigene Hintergrundlicht-Unterdrückungsschaltung besitzen.

Es ist auch möglich, dass für jeden Empfangskanal eine eigene Klemmschaltung und/oder ein eigener Nachverstärker vorgesehen ist. Allerdings ist es zugunsten einer Verringerung der erforderlichen elektronischen Bausteine bevorzugt, wenn für alle Empfangskanäle nicht nur ein gemeinsamer Komparator, sondern auch eine gemeinsame Klemmschaltung und/oder ein gemeinsamer Nachverstärker vorgesehen sind.

Für eine besonders kostengünstige Herstellung kann die Auswerteschaltung zumindest teilweise, insbesondere für jeden Empfangskanal, in integrierter Bauweise gefertigt sein.

Hinsichtlich der zeitlichen Abfolge des Aktivierens eines Empfangskanals ist es bevorzugt, wenn die Klemmschaltung aktiviert wird, nachdem der vorgeschaltete Differenzverstärker aktiviert worden und eingeschwungen ist. Der Lichtempfänger des betreffenden Empfangskanals wird vorzugsweise erst dann mit dem Differenzverstärker verbunden, wenn die Klemmschaltung wieder deaktiviert worden ist. Anschließend kann das Ausgangssignal des Differenzverstärkers im Komparator mit dem Schwellenwert verglichen werden.

Die Erfindung bezieht sich somit auch auf einen vollständigen optoelektronischen Sensor, insbesondere ein Lichtgitter, mit einem oder mehreren Sendern zum Aussenden von Sendelicht sowie mit wenigstens einem, vorzugsweise einer Vielzahl von Empfängern zum Empfangen des Sendelichts und zur Ausgabe eines entsprechenden Empfangssignals, wobei dieser Sensor eine Auswerteschaltung der erläuterten Art besitzt.

Weitere Ausführungsformen der Erfindung sind in den Unteransprüchen genannt.

Die Erfindung wird nachfolgend beispielhaft unter Bezugnahme auf die Zeichnungen erläutert; in diesen zeigen:
- Fig. 1: eine Auswerteschaltung mit einem Empfangskanal,
- Fig. 2: eine Auswerteschaltung mit einer Vielzahl von Empfangskanälen,
- Fig. 3: ein Ausführungsbeispiel einer Klemmschaltung, und
- Fig. 4: ein weiteres Ausführungsbeispiel einer Klemmschaltung.

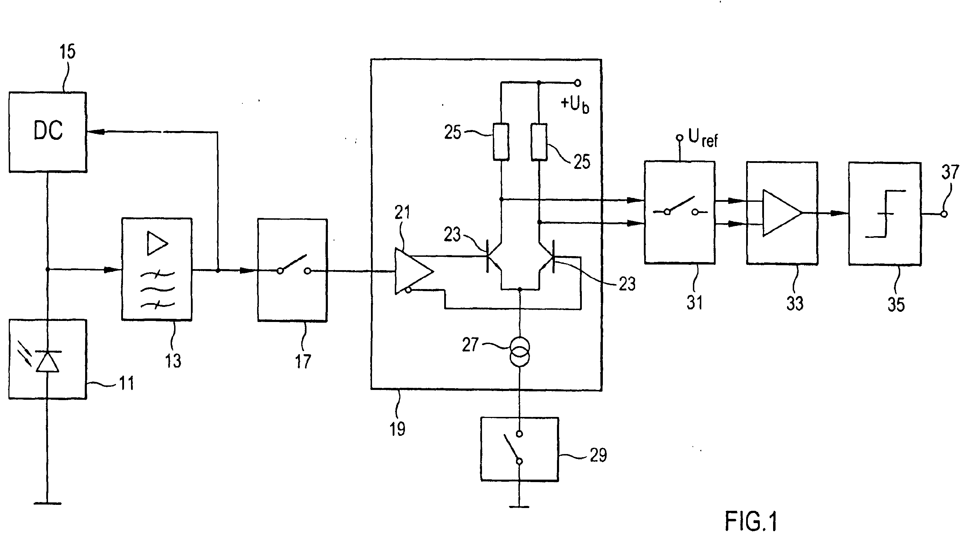

Fig. 1 zeigt eine erfindungsgemäße Auswerteschaltung für einen Empfangskanal eines Lichtgitters. Diese Auswerteschaltung besitzt eingangsseitig einen optoelektronischen Empfänger in Form einer Fotodiode 11. Die Fotodiode 11 ist ausgangsseitig mit einem Transimpedanzverstärker 13 verbunden, der gleichzeitig als Bandpass fungiert. Der Transimpedanzverstärker 13 ist über eine Hintergrundlicht-Unterdrückungsschaltung 15 rückgekoppelt. Diese Schaltung 15 bildet somit einen Regelkreis, durch den der Einfluss des von der Fotodiode 11 detektierten Hintergrundlichts unterdrückt wird, indem aufgrund eines Vergleichs mit einer Sollspannung ein entsprechender Strom mit negativem Vorzeichen in den Eingang des Transimpedanzverstärkers 13 eingespeist wird.

Ausgangsseitig ist der Transimpedanzverstärker 13 über einen Schalter 17 mit einem Differenzverstärker 19 verbunden, der eine Eingangsstufe 21 und eine Ausgangsstufe aufweist. Diese Ausgangsstufe besitzt in bekannter symmetrischer Anordnung zwei Verstärkungstransistoren 23, deren Kollektoren über einen jeweiligen Widerstand 25 von einer gemeinsamen Betriebsspannung U_{b} gespeist werden und deren Emitter mit einer Stromquelle 27 verbunden sind. Die Stromquelle 27 kann über einen Schalter 29 ein- und ausgeschaltet werden.

Somit erfolgt die Verstärkung des Empfangssignals der Fotodiode 11 innerhalb des Transimpedanzverstärkers 13 mit Bandpass zunächst in unsymmetrischer Weise und nachfolgend - nämlich ab der Eingangsstufe 21 des Differenzverstärkers 19 - symmetrisch.

Die beiden differentiellen Ausgangssignale des Differenzverstärkers 19 werden einer Klemmschaltung 31 zugeführt, die mit einem Referenzpotential U_{ref} versorgt wird und deren genauerer Aufbau und Funktionsweise nachfolgend noch erläutert werden.

Die beiden derartig verstärkten differentiellen Empfangssignale werden nachfolgend einem Nachverstärker 33 zugeführt, der ein nachverstärktes unsymmetrisches Ausgangssignal an einen Komparator 35 weiterleitet. Der Komparator 35 liefert an seinen Ausgang 37 ein Warn- oder Abschaltsignal, falls das Signal des Nachverstärkers 33 innerhalb eines Erwartungszeitfensters einen vorbestimmten Schwellenwert unterschreitet.

Die Erzeugung und Verarbeitung eines Empfangssignals erfolgt innerhalb der Auswerteschaltung gemäß Fig. 1 prinzipiell wie folgt:

Zunächst wird mittels eines der Fotodiode 11 zugeordneten, in Fig. 1 nicht dargestellten Lichtsenders des Lichtgitters ein Lichtpuls erzeugt. Falls dieser Lichtpuls die Fotodiode 11 ungestört, also ohne Unterbrechung des Lichtstrahls erreicht, so erzeugt die Fotodiode 11 ein pulsförmiges Empfangssignal.

Dieses Empfangssignal wird innerhalb des Transimpedanzverstärkers 13 verstärkt und gefiltert. Bei geschlossenem Schalter 17 und bei mittels des Schalters 29 eingeschaltetem Differenzverstärker 19 wird das Empfangssignal weiter verstärkt und mittels des Nachverstärkers 33 nachverstärkt. Schließlich wird mittels des Komparators 35 überprüft, ob das derartig verstärkte Empfangssignal einen vorbestimmten Schwellenwert überschreitet.

Falls dagegen der Strahlengang unterbrochen ist, also falls beispielsweise ein unbefugter Eingriff in eine entsprechende Stelle des Überwachungsbereichs des Lichtgitters erfolgt, so wird am Komparator 35 festgestellt, dass innerhalb eines mit dem Aussenden des Lichtpulses synchronisierten Erwartungszeitfensters kein ausreichend hohes Empfangssignal vorliegt. In diesem Fall gibt der Komparator 35 das bereits erwähnte Warn- bzw. Abschaltsignal aus.

Bei der erläuterten Verarbeitung des Empfangssignals bewirkt die Klemmschaltung 31 eine Unterdrückung eines störenden Einflusses eines möglichen Offset am Ausgang des Differenzverstärkers 19. Falls nämlich der Differenzverstärker 19 - zum Zwecke einer kostengünstigen Herstellung in großen Stückzahlen - vergleichsweise hohe Kennzahltoleranzen seiner Bauelemente besitzt, kann der differentielle Ausgang des Differenzverstärkers 19 einen Offset, also eine Stromdifferenz aufweisen, selbst wenn am Eingang des Verstärkers 19 überhaupt kein Signal anliegt oder der Eingang kurzgeschlossen ist. Damit ein derartiger Offset infolge seiner Nachverstärkung im Nachverstärker 33 keine vermeintliche Detektion eines Empfangssignals durch den Komparator 35 bewirkt, wird der Offset mittels der Klemmschaltung 31 unterdrückt.

Dies geschieht dadurch, dass mittels der Klemmschaltung 31 die beiden Ausgänge des Differenzverstärkers 19 auf den Referenzpegel U_{ref} geklemmt werden. Somit werden am Nachverstärker 33 nur solche Differenzen der beiden Eingangssignale festgestellt, die tatsächlich auf ein (verstärktes) Empfangssignal der Fotodiode 11 zurückzuführen sind.

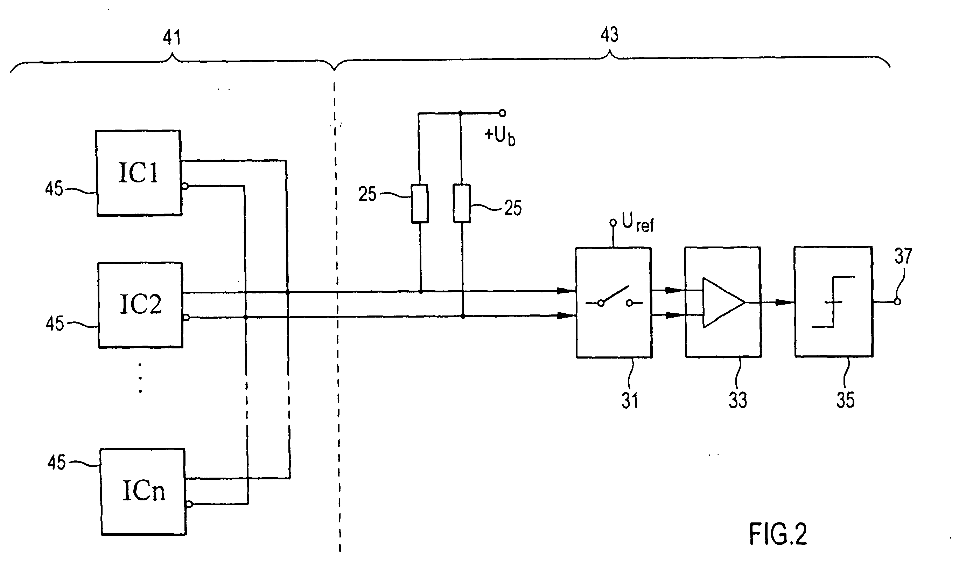

Eine besonders kostengünstige Herstellung des erläuterten Lichtgitters mit einer Vielzahl von Sendekanälen und zugeordneten Empfangskanälen wird dadurch erreicht, dass die Auswerteelektronik empfangskanalweise auf einer Empfängerplatine 41 und - für alle Empfangskanäle zusammengefasst - auf einer Basisplatine 43 realisiert ist, wie in Fig. 2 gezeigt. Seitens der Empfängerplatine 41 ist für jeden Empfangskanal ein integrierter Schaltkreis 45 vorgesehen. Jeder integrierte Schaltkreis 45 enthält im Wesentlichen die Fotodiode 11, den Transimpedanzverstärker 13 mit Bandpass, die Hintergrundlicht-Unterdrückungsschaltung 15, den Schalter 17 sowie den Differenzverstärker 19 mit Schalter 29, wobei jedoch die Kollektorwiderstände 25 mit der Zufuhr der Betriebsspannung U_{b} seitens der Basisplatine 43 vorgesehen sind.

Im übrigen enthält die Basisplatine 43 gemeinsam für alle Empfangskanäle die Klemmschaltung 31, den Nachverstärker 33 und den Komparator 35.

Der genauere Ablauf der empfangsseitigen Signalverarbeitung des Lichtgitters gemäß Fig. 1 und 2 geschieht wie folgt:

Beim Einschalten des Lichtgitters werden die Fotodioden 11, die Transimpedanzverstärker 13, die Hintergrundlicht-Unterdrückungsschaltungen 15 und die Schalter 17 aller Empfangskanäle, d.h. aller integrierter Schaltkreise 45 aktiviert, wobei alle Schalter 17 offen, d.h. ausgeschaltet sind. Diese Baugruppen bleiben im weiteren Verlauf stets aktiviert, so dass die Funktionsweise der Hintergrundlichtkompensation mit der zwangsläufig großen Zeitkonstante der Schaltung 15 stets gewährleistet ist.

Um die Aktivierung des ersten Empfangskanals einzuleiten, wird nun der Schalter 29 des zugehörigen Differenzverstärkers 19 geschlossen. Somit ist die Ausgangsstufe dieses Differenzverstärkers 19 und damit der integrierte Schaltkreis 45 des betreffenden Empfangskanals aktiviert, und nach Beendigung des entsprechenden Einschwingvorgangs weisen die beiden Ausgänge des Differenzverstärkers 19 möglicherweise einen Offset auf.

Indem jetzt die Klemmschaltung 31 aktiviert wird, werden die beiden Ausgänge des gerade aktivierten Differenzverstärkers 19 bzw. die beiden Eingänge des nachgeordneten Differenzverstärkers 33 auf denselben Referenzpegel U_{ref} geklemmt. Anschließend wird die Klemmschaltung 31 wieder deaktiviert. Der Referenzpegel wird nun mit einer - im Verhältnis zur Breite des erwarteten Empfangssignals - großen Zeitkonstante gespeichert.

Anschließend wird der Schalter 17 des Schaltkreises 45 geschlossen, um die Signalverarbeitungskette des betreffenden Empfangskanals zu schließen. Nach dem nachfolgenden Einschwingen der symmetrischen Eingangsstufe 21 des Differenzverstärkers 19 wird der Sendelichtpuls aktiviert und mittels der zugeordneten Fotodiode 11 detektiert. Das Empfangssignal der Fotodiode 11 wird in der bereits erläuterten Weise gewandelt, verstärkt und mittels des Komparators 35 bewertet.

Nach dem Ende des für diesen ersten Empfangskanal vorgesehenen Zeitintervalls werden die zugeordneten Schalter 29 und 17 wieder geöffnet, so dass erneut alle Schalter 29, 17 der Auswerteschaltung des Lichtgitters geöffnet sind.

Nachfolgend kann das Auswertezeitintervall für den zweiten Empfangskanal beginnen, wobei in entsprechender Weise verfahren wird. Zunächst wird also wieder der zugeordnete Schalter 29 geschlossen, um den betreffenden Differenzverstärker 19 zu aktivieren. Anschließend werden die Eingangspegel des Nachverstärkers 33 wieder zeitweilig auf den Referenzpegel U_{ref} geklemmt. Danach wird der zugeordnete Schalter 17 geschlossen, und das eigentliche Pulssignal kann übertragen und bewertet werden.

Auf diese Weise werden zyklisch nacheinander alle Empfangskanäle aktiviert und ausgewertet.

Abweichungen von dem beschriebenen Zeitablauf sind möglich. Insbesondere kann, um höhere Tastraten zu erreichen, während des Verarbeitens und Bewertens eines bestimmten Empfangskanals bereits der nächste Empfangskanal bzw. der diesem zugeordnete integrierte Schaltkreis 45 aktiviert werden. Weiterhin ist es auch möglich, den jeweiligen Differenzverstärker 19 erst mit oder nach dem Aktivieren der Klemmschaltung 31 zu aktivieren. Außerdem ist es auch möglich, durch Schließen des Schalters 17 die Fotodiode 11 bereits vor dem Deaktivieren der Klemmschaltung 31 mit dem Differenzverstärker zu verbinden.

Die erläuterte Klemmschaltung 31 enthält wenigstens zwei elektronische Schalter sowie zwei Kondensatoren als analoge Speichereinrichtungen, die als Koppelkondensatoren zwischen dem von der Empfängerplatine 41 gebildeten Analogbus und dem nachgeschalteten Differenzverstärker 33 der Basisplatine 43 realisiert werden können.

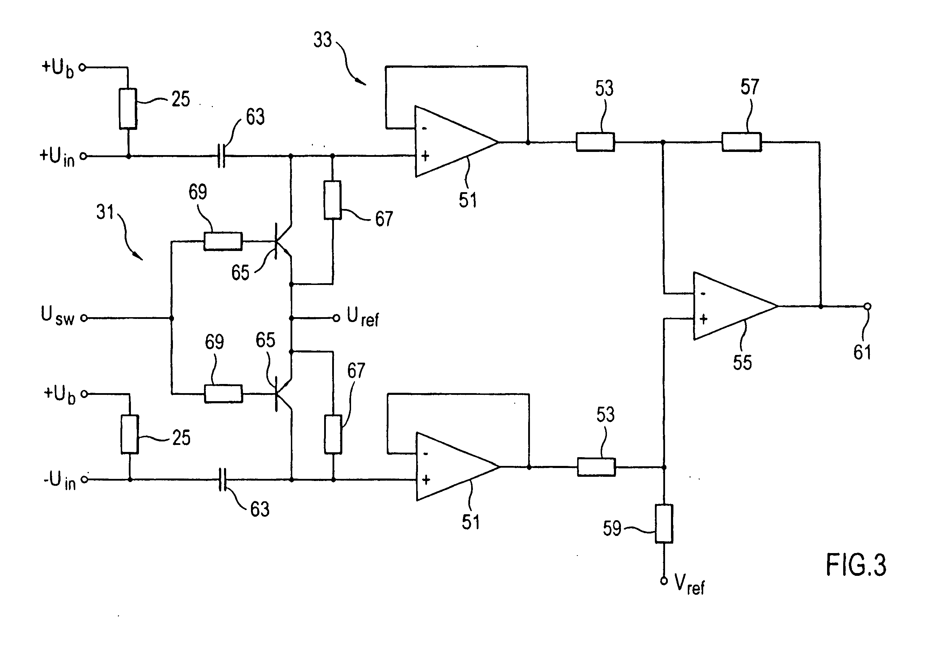

Fig. 3 zeigt ein mögliches Ausführungsbeispiel der Klemmschaltung 31 gemäß Fig. 1 und 2. Gezeigt ist in Fig. 3 neben der Klemmschaltung 31 zum einen auch ein Teil des vorgeschalteten Differenzverstärkers 19, nämlich die beiden Kollektorwiderstände 25, über welche die Betriebsspannung U_{b} eingespeist wird. Zum anderen zeigt Fig. 3 zusätzlich den nachgeschalteten Differenzverstärker 33. Dieser ist durch zwei Operationsverstärker 51 zur Impedanzanpassung und nachgeschaltete Widerstände 53 in symmetrischer Anordnung sowie - als unsymmetrische Ausgangsstufe - einen Operationsverstärker 55 mit Rückkopplungswiderstand 57 gebildet. Der positive Eingang des Operationsverstärkers 55 wird über einen Widerstand 59 mit einem Bezugspotential V_{ref} gespeist. Der Ausgang 61 des Operationsverstärkers 55 liegt - bezogen auf Fig. 1 und 2 - somit an dem Komparator 35 an.

Die eigentliche Klemmschaltung 31 gemäß Fig. 3 weist zwei Koppelkondensatoren 63 auf, die als analoge Speichereinrichtungen dienen. Diese Speicherkondensatoren 63 sind in Serie zwischen den jeweiligen Eingang +Uᵢₙ, -Uᵢₙ der Klemmschaltung 31 und den jeweiligen positiven Eingang der symmetrischen Operationsverstärker 51 geschaltet.

Zwei Transistoren 65 dienen als elektronische Klemmschalter. Die Schalttransistoren 65 sind gemeinsam mit den Speicherkondensatoren 63 symmetrisch zu dem positiven und negativen Eingang +Uᵢₙ bzw. -Uᵢₙ der Klemmschaltung 31 angeordnet: der jeweilige Kollektor ist mit dem zugeordneten Speicherkondensator 63 bzw. dem positiven Eingang des zugeordneten Operationsverstärkers 51 verbunden. Die Emitter der beiden Schalttransistoren 65 liegen auf dem gemeinsamen Referenzpotential U_{ref}, und sie sind ferner über einen jeweiligen Entladewiderstand 67 mit dem Kollektor bzw. dem positiven Eingang des jeweiligen symmetrischen Operationsverstärkers 51 verbunden.

Das Aktivieren und Deaktivieren der Schalttransistoren 65 erfolgt über einen jeweiligen Basiswiderstand 69 durch Anlegen eines TTL-Schaltsignals an einem gemeinsamen Schalteingang U_{sw}.

Die in Fig. 3 gezeigte Klemmschaltung 31 funktioniert wie folgt:

Zum Aktivieren der Klemmschaltung 31 werden die beiden Schalttransistoren 65 durchgeschaltet (TTL "high" am Schalteingang U_{sw}). Dadurch wird der jeweilige positive Eingang der beiden symmetrischen Operationsverstärker 51 auf das Referenzpotential U_{ref} geschaltet. Die Speicherkondensatoren 63 werden mit kurzer Zeitkonstante aufgeladen.

Zum Deaktivieren der Klemmschaltung 31 werden die Schalttransistoren 65 ausgeschaltet (TTL "low" am Schalteingang U_{sw}). Mit dem Ausschalten der Schalttransistoren 65 verbleibt das Referenzpotential U_{ref} auf den Kondensatorplatten der Speicherkondensatoren 63. Die Gültigkeit dieses Potentials wird von der (Entlade-)Zeitkonstante bestimmt, die sich aus dem Produkt der jeweiligen Kapazität der Speicherkondensatoren 63 und dem jeweiligen Widerstandswert der Widerstände 67 ergibt. Trotz der erfolgten Klemmung kann in diesem Zustand ein über den jeweiligen Signaleingang +Uᵢₙ bzw. -Uᵢₙ zugeführter Empfangssignalpuls über den betreffenden Speicherkondensator 63 ungehindert den positiven Eingang des jeweiligen Operationsverstärkers 51 erreichen.

Ein besonderer Vorteil der in Fig. 3 gezeigten Klemmschaltung besteht darin, dass sich das Entlade-Schlusspotential an den Speicherkondensatoren 63 gegenüber dem Sollpotential, also dem Referenzpotential U_{ref}, nur geringfügig ändern kann, nämlich um das Produkt aus dem jeweiligen Bias-Strom (Vorstrom) des positiven Eingang des Operationsverstärkers 51 und dem jeweiligen Entladewiderstand 67. In der Praxis handelt es sich hier um lediglich einige 10 bis 100 mV. Selbst diese Änderung wird bei der symmetrischen Dimensionierung der Speicherkondensatoren 63, der Entladewiderstände 67, der Schalttransistoren 65 und der symmetrischen Operationsverstärker 51 vollständig weggerechnet, da es sich hier um eine Gleichtaktspannung handelt, die im Differenzverstärker 33 nicht verstärkt wird.

Ein weiterer Vorteil der Klemmschaltung 31 gemäß Fig. 3 ist darin zu sehen, dass diese mit der lediglich einen Betriebsspannung +U_{b} auskommt.

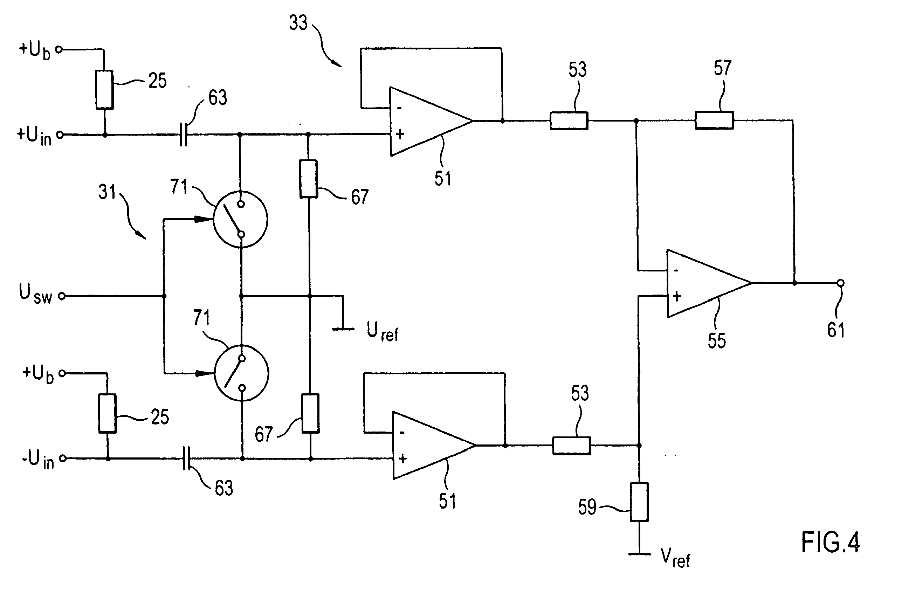

Fig. 4 zeigt eine weitere Ausführungsform der Klemmschaltung 31 gemäß Fig. 1 und 2, bei der das Referenzpotential U_{ref} auf Masse liegt. Diese Klemmschaltung 31 entspricht im Wesentlichen derjenigen gemäß Fig. 3. Allerdings werden anstelle der Schalttransistoren 65 zwei Analogschalter 71 eingesetzt. Außerdem wird für die Analogschalter 71 sowie die Operationsverstärker 51, 55 eine bipolare Betriebsspannung verwendet (nicht dargestellt).

Zu den erläuterten Ausführungsformen ist noch anzumerken, dass anstelle der Widerstände 25 jeweils auch eine Stromquelle oder ein Stromspiegel als Arbeitswiderstand des Differenzverstärkers 19 (Fig. 1) eingesetzt werden kann.

Die beiden Operationsverstärker 51 (Fig. 3 und 4) können auch mit einer Verstärkung größer eins betrieben werden. Um die Symmetrie der Anordnung zu wahren, ist für beide Operationsverstärker 51 die gleiche Verstärkung vorzusehen.

### Bezugszeichenliste

- 11: Fotodiode
- 13: Transimpedanzverstärker
- 15: Hintergrundlicht-Unterdrückungsschaltung
- 17: Schalter
- 19: Differenzverstärker
- 21: Eingangsstufe
- 23: Verstärkungstransistor
- 25: Kollektorwiderstand
- 27: Stromquelle
- 29: Schalter
- 31: Klemmschaltung
- 33: Nachverstärker
- 35: Komparator
- 37: Ausgang des Komparators
- 41: Empfängerplatine
- 43: Basisplatine
- 45: integrierter Schaltkreis
- 51: Operationsverstärker
- 53: Widerstand
- 55: Operationsverstärker
- 57: Rückkopplungswiderstand
- 59: Widerstand
- 61: Ausgang des Nachverstärkers
- 63: Speicherkondensator
- 65: Schalttransistor
- 67: Entladewiderstand
- 69: Basiswiderstand
- 71: Analogschalter
- U_{b}: Betriebsspannung
- U_{ref}: Referenzpotential
- Uᵢₙ: Signaleingang
- U_{sw}: Schalteingang
- V_{ref}: Bezugspotential

## Patentansprüche

1. Auswerteschaltung zur Verarbeitung eines differentiellen Empfangssignals eines optoelektronischen Sensors, insbesondere eines Lichtgitters,
wenigstens mit einem Differenzverstärker (19) zum Verstärken des Empfangssignals, wobei der Differenzverstärker (19) zwei Ausgänge zum Ausgeben differentieller Ausgangssignale besitzt,
wobei die Auswerteschaltung einen Nachverstärker (33) aufweist, der zwei Eingänge besitzt, die mit den Ausgängen des Differenzverstärkers (19) verbunden sind, wobei der Nachverstärker (33) ein unsymmetrisches Ausgangssignal erzeugt, und
wobei die Auswerteschaltung eine Klemmschaltung (31) aufweist, die zwischen dem Differenzverstärker (19) und dem Nachverstärker (33) angeordnet ist,
**dadurch gekennzeichnet,**
**dass** die Klemmschaltung (31) zwei Koppelkondensatoren (63) aufweist, die jeweils zwischen einem Ausgang des Differenzverstärkers (19) und einem Eingang des Nachverstärkers (33) in Serie geschaltet sind, und
**dass** mittels der Klemmschaltung (31) die Eingänge des Nachverstärkers (33) auf ein Referenzpotential (U_{ref}) schaltbar sind.

2. Auswerteschaltung nach Anspruch 1,
**dadurch gekennzeichnet,**
**dass** die Eingänge des Nachverstärkers (33) mittels der Klemmschaltung (31) zeitweilig auf das Referenzpotential (U_{ref}) schaltbar sind, und/oder
**dass** die Eingänge des Nachverstärkers (33) auf ein gemeinsames Referenzpotential (U_{ref}) schaltbar sind.

3. Auswerteschaltung nach einem der vorhergehenden Ansprüche,
**dadurch gekennzeichnet,**
**dass** die Klemmschaltung (31) wenigstens einen elektronischen Schalter (65, 71) und wenigstens einen Entladewiderstand (67) aufweist, die parallel zueinander zwischen einem zugeordneten Eingang des Nachverstärkers (33) und dem Referenzpotential (U_{ref}) angeordnet sind,
wobei die Klemmschaltung (31) vorzugsweise zwei Schalter (65, 71) und zwei Entladewiderstände (67) aufweist, die im Wesentlichen symmetrisch angeordnet sind.

4. Auswerteschaltung nach einem der vorhergehenden Ansprüche,
**dadurch gekennzeichnet,**
**dass** die die Koppelkondensatoren (63) im Wesentlichen symmetrisch angeordnet sind, und/oder
**dass** die zwei Ausgänge des Differenzverstärkers (19) symmetrisch sind und die zwei Eingänge des Nachverstärkers (33) symmetrisch sind.

5. Auswerteschaltung nach einem der vorhergehenden Ansprüche,
**dadurch gekennzeichnet,**
**dass** ein Ausgang des Nachverstärkers (33) mit einem Komparator (35) zum Vergleich eines Empfangssignals mit einem Schwellenwert verbunden ist, und/oder
**dass** die Auswerteschaltung einen Empfänger - insbesondere eine Photodiode (11) -, einen Transimpedanzverstärker (13), einen Bandpass (13) und/oder eine Hintergrundlicht-Unterdrückungsschaltung (15) aufweist.

6. Auswerteschaltung nach einem der vorhergehenden Ansprüche,
**dadurch gekennzeichnet,**
**dass** die Auswerteschaltung eine Vielzahl von Empfangskanälen (45) aufweist,
wobei die Auswerteschaltung vorzugsweise wenigstens acht, insbesondere wenigstens hundert Empfangskanäle (45) aufweist.

7. Auswerteschaltung nach Anspruch 6,
**dadurch gekennzeichnet,**
**dass** die Empfangskanäle nacheinander aktivierbar sind, und/oder dass durch Aktivieren eines jeweils zugeordneten elektronischen Schalters (17, 29) und/oder durch Aktivieren eines jeweils zugeordneten Differenzverstärkers (19) wahlweise einer der Empfangskanäle (45) aktivierbar ist, und/oder
**dass** für alle Empfangskanäle (45) jeweils ein eigener Differenzverstärker (19) - und vorzugsweise jeweils ein eigener Empfänger (11), ein eigener Transimpedanzverstärker (13), ein eigener Bandpass (13) und/oder eine eigene Hintergrundlicht-Unterdrückungsschaltung (15) - vorgesehen ist, und/oder
**dass** für alle Empfangskanäle (45) ein gemeinsamer Komparator (35) - und vorzugsweise eine gemeinsame Klemmschaltung (31) und/oder ein gemeinsamer Nachverstärker (33) - vorgesehen ist.

8. Optoelektronischer Sensor, insbesondere Lichtgitter,
mit einem oder einer Vielzahl von Sendern zum Aussenden von Sendelicht,
ferner mit wenigstens einem, vorzugsweise einer Vielzahl von Empfängern (11) zum Empfangen von Sendelicht und zur Ausgabe eines entsprechenden Empfangssignals, und
mit einer Auswerteschaltung nach einem der vorhergehenden Ansprüche.

9. Verfahren zur Verarbeitung eines differentiellen Empfangssignals eines optoelektronischen Sensors, insbesondere eines Lichtgitters, bei dem das Empfangssignal mittels eines Differenzverstärkers (19) verstärkt wird, der an zwei Ausgängen differentielle Ausgangssignale ausgibt,
wobei die zwei Ausgänge des Differenzverstärkers (19) mit zwei Eingängen eines Nachverstärkers (33) verbunden werden, der ein unsymmetrisches Ausgangssignal erzeugt, und
wobei eine Klemmschaltung (31) zwischen dem Differenzverstärker (19) und dem Nachverstärker (33) angeordnet wird,
**dadurch gekennzeichnet,**
**dass** die Klemmschaltung (31) zwei Koppelkondensatoren (63) aufweist, die jeweils zwischen einem Ausgang des Differenzverstärkers (19) und einem Eingang des Nachverstärkers (33) in Serie geschaltet werden, und
**dass** die Klemmschaltung (31) die Eingänge des Nachverstärkers (33) auf ein Referenzpotential (U_{ref}) schaltet.

10. Verfahren nach Anspruch 9,
**dadurch gekennzeichnet,**
**dass** die Eingänge des Nachverstärkers (33) zeitweilig auf das Referenzpotential (U_{ref}) geschaltet werden, insbesondere durch zeitweiliges Aktivieren wenigstens eines elektronischen Schalters (65, 71) der Klemmschaltung (31), und/oder
**dass** die Eingänge des Nachverstärkers (33) auf ein gemeinsames Referenzpotential (U_{ref}) geschaltet werden, und/oder
**dass** das Referenzpotential (U_{ref}) mittels der Koppelkondensatoren (63) der Klemmschaltung (31) zumindest zeitweise an den Eingängen des Nachverstärkers (33) gespeichert wird, und/oder
**dass** der Differenzverstärker (19) vor oder nach dem Aktivieren der Klemmschaltung (31) aktiviert wird.

11. Verfahren nach einem der Ansprüche 9 und 10,
**dadurch gekennzeichnet,**
**dass** nach oder vor einem Deaktivieren der Klemmschaltung (31) ein Empfänger (11) mit einem Eingang des Differenzverstärkers (19) verbunden wird - insbesondere durch Einschalten eines zugeordneten elektronischen Schalters (17) -, und
**dass** danach das - insbesondere nachverstärkte - Ausgangssignal des Differenzverstärkers (19) mit einem Schwellenwert verglichen wird.

12. Verfahren nach einem der Ansprüche 9 bis 11,
**dadurch gekennzeichnet,**
**dass** nacheinander jeweils das Empfangssignal eines von mehreren Empfangskanälen (45) verarbeitet wird,
wobei der betreffende Empfangskanal (45) insbesondere durch Aktivieren eines jeweils zugeordneten Differenzverstärkers (19) und/oder durch Einschalten eines jeweils zugeordneten elektronischen Schalters (17, 26) ausgewählt wird.

## Claims

1. An evaluation circuit for the processing of a received differential signal of an optoelectronic sensor, in particular of a light grid, at least comprising one differential amplifier (19) for the amplification of the received signal, wherein the differential amplifier (19) has two outputs for the outputting of differential output signals,
wherein the evaluation circuit has a follow-up amplifier (33) which has two inputs which are connected to the outputs of the differential amplifier (19), with the follow-up amplifier (33) generating an asymmetrical output signal, and
wherein the evaluation circuit has a clamping circuit 31 which is arranged between the differential amplifier (19) and the follow-up amplifier (33),
**characterized in that** the clamping circuit (31) has two coupling capacitors (63) which are each connected in series between an output of the differential amplifier (19) and an input of the follow-up amplifier (33); and
**in that** the inputs of the follow-up amplifier (33) can be switched to a reference potential (U_{ref}) by means of the clamping circuit (31).

2. An evaluation circuit in accordance with claim 1, **characterized in that** the inputs of the follow-up amplifier (33) can be switched to the reference potential (U_{ref}) temporarily by means of the clamping circuit (31); and/or **in that** the inputs of the follow-up amplifier (33) can be switched to a common reference potential (U_{ref}).

3. An evaluation circuit in accordance with any one of the preceding claims, **characterized in that** the clamping circuit (31) has at least one electronic switch (65, 71) and at least one discharge resistor (67) which are arranged parallel to one another between an associated input of the follow-up amplifier (33) and the reference potential (U_{ref}),
wherein the clamping circuit (31) preferably has two switches (65, 71) and two discharge resistors (67) which are arranged substantially symmetrically.

4. An evaluation circuit in accordance with any one of the preceding claims, **characterized in that** the coupling capacitors (63) are arranged substantially symmetrically; and/or **in that** the two outputs of the differential amplifier (19) are symmetrical and the two inputs of the follow-up amplifier (33) are symmetrical.

5. An evaluation circuit in accordance with any one of the preceding claims, **characterized in that** an output of the follow-up amplifier (33) is connected to a comparator (35) for the comparison of a received signal with a threshold value; and/or **in that** the evaluation circuit has a receiver - in particular a photodiode (11) - a transimpedance amplifier (13), a band-pass (13) and/or a background light suppression circuit (15).

6. An evaluation circuit in accordance with any one of the preceding claims, **characterized in that** the evaluation circuit has a plurality of reception channels (45), with the evaluation circuit preferably having at least eight reception channels (45), in particular at least one hundred reception channels (45).

7. An evaluation circuit in accordance with claim 6, **characterized in that** the reception channels can be activated successively; and/or **in that** one of the reception channels (45) can be selectively activated by activation of a respectively associated electronic switch (17, 29) and/or by activation of a respectively associated differential amplifier (19); and/or **in that** a respective separate differential amplifier (19) - and preferably a respective separate receiver (11), a respective separate transimpedance amplifier (13), a respective separate bandpass (13) and/or a respective separate background light suppression circuit (15) - is/are provided for each reception channel (45); and/or **in that** a common comparator (35) - and preferably a common clamping circuit (31) and/or a common follow-up amplifier (33) - is/are provided for all reception channels (45).

8. An optoelectronic sensor, in particular a light grid,
comprising one transmitter, or a plurality of transmitters, for the transmission of transmitted light,
further comprising at least one receiver (11), preferably a plurality of receivers (11), for the reception of transmitted light and for the outputting of a corresponding received signal, and
comprising an evaluation circuit in accordance with any one of the preceding claims.

9. A method for the processing of a received differential signal of an optoelectronic sensor, in particular of a light grid, wherein the received signal is amplified by means of a differential amplifier (19), which outputs differential output signals at two outputs,
wherein the two outputs of the differential amplifier (19) are connected to two inputs of a follow-up amplifier (33) which generates an asymmetrical output signal, and
wherein a clamping circuit (31) is arranged between the differential amplifier (19) and the follow-up amplifier (33),
**characterized in that**
the clamping circuit (31) has two coupling capacitors (63) which are each connected in series between an output of the differential amplifier (19) and an input of the follow-up amplifier (33); and
**in that** the clamping circuit (31) switches the inputs of the follow-up amplifier (33) to a reference potential (U_{ref}).

10. A method in accordance with claim 9, **characterized in that** the inputs of the follow-up amplifier (33) are switched temporarily to the reference potential (U_{ref}), in particular by temporary activation of at least one electronic switch (65, 71) of the clamping circuit (31); and/or **in that** the inputs of the follow-up amplifier (33) are switched to a common reference potential (U_{ref}); and/or **in that** the reference potential (U_{ref}) is stored at least temporarily at the inputs of the follow-up amplifier (33) by means of the coupling capacitors (63); and/or **in that** the differential amplifier (19) is activated before or after the activation of the clamping circuit (31).

11. A method in accordance with any one of the claims 9 and 10, **characterized in that** a receiver (11) is connected to an input of the differential amplifier (19) - in particular by switching on an associated electronic switch (17) - after or before a deactivation of the clamping circuit (31); and **in that** thereafter the output signal, in particular the post-amplified output signal, of the differential amplifier (19) is compared with a threshold value.

12. A method in accordance with any one of the claims 9 to 11, **characterized in that** the respective received signal of one of a plurality of reception channels (45) is sequentially processed, wherein the relevant reception channel (45) is in particular selected by activation of a respectively associated differential amplifier (19) and/or by switching on a respectively associated electronic switch (17, 26).

## Revendications

1. Circuit d'évaluation pour traiter un signal de réception différentiel d'un capteur optoélectronique, en particulier d'une grille lumineuse,
comportant au moins un amplificateur différentiel (19) pour amplifier le signal de réception, l'amplificateur différentiel (19) possédant deux sorties pour émettre des signaux de sortie différentiels,
le circuit d'évaluation présentant un amplificateur de récupération (33) qui possède deux entrées qui sont reliées aux sorties de l'amplificateur différentiel (19), l'amplificateur de récupération (33) produisant un signal de sortie asymétrique, et
le circuit d'évaluation présente un circuit de blocage (31) qui est agencé entre l'amplificateur différentiel (19) et l'amplificateur de récupération (33),
**caractérisé en ce que**
le circuit de blocage (31) présente deux condensateurs de couplage (63) qui sont chacun branchés en série entre une sortie de l'amplificateur différentiel (19) et une entrée de l'amplificateur de récupération (33), et **en ce que** les entrées de l'amplificateur de récupération (33) peuvent être branchées un potentiel de référence (U_{ref}) au moyen du circuit de blocage (31).

2. Circuit d'évaluation selon la revendication 1,
**caractérisé en ce que**
les entrées de l'amplificateur de récupération (33) peuvent être branchées temporairement au potentiel de référence (U_{ref}) au moyen du circuit de blocage (31),
et/ou
**en ce que** les entrées de l'amplificateur de récupération (33) peuvent être branchées à un potentiel de référence (U_{ref}) commun.

3. Circuit d'évaluation selon l'une des revendications précédentes,
**caractérisé en ce que**
le circuit de blocage (31) présente au moins un commutateur électronique (65, 71) et au moins une résistance de décharge (67) qui sont agencés parallèlement l'un à l'autre entre une entrée associée de l'amplificateur de récupération (33) et le potentiel de référence (U_{ref}),
le circuit de blocage (31) présentant de préférence deux commutateurs (65, 71) et deux résistances de décharge (67) qui sont agencés de manière sensiblement symétrique.

4. Circuit d'évaluation selon l'une des revendications précédentes,
**caractérisé en ce que**
les condensateurs de couplage (63) sont agencés de manière sensiblement symétrique, et/ou
**en ce que** les deux sorties de l'amplificateur différentiel (19) sont symétriques et les deux entrées de l'amplificateur de récupération (33) sont symétriques.

5. Circuit d'évaluation selon l'une des revendications précédentes,
**caractérisé en ce que**
une entrée de l'amplificateur de récupération (33) est reliée à un comparateur (35) pour comparer un signal de réception avec une valeur seuil, et/ou
le circuit d'évaluation présente un récepteur - en particulier une photodiode (11) -, un amplificateur à transimpédance (13), un filtre passe-bande (13) et/ou un circuit de suppression de lumière d'arrière-plan (15).

6. Circuit d'évaluation selon l'une des revendications précédentes,
**caractérisé en ce que**
le circuit d'évaluation présente une multitude de canaux de réception (45),
le circuit d'évaluation présentant de préférence au moins huit, en particulier au moins cent canaux de réception (45).

7. Circuit d'évaluation selon la revendication 6,
**caractérisé en ce que**
les canaux de réception peuvent être activés les uns après les autres, et/ou **en ce qu'**en activant un commutateur électronique (17, 29) respectivement associé et/ou en activant un amplificateur différentiel (19) respectivement associé, un des canaux de réception (45) peut être activé au choix, et/ou
**en ce que** pour tous les canaux de réception (45), il est respectivement prévu un amplificateur différentiel (19) propre - et de préférence un récepteur (11) propre, un amplificateur de transimpédance (13) propre, une filtre passe-bande (13) propre et/ou un circuit de suppression de lumière d'arrière-plan (15) propre, et/ou
**en ce que** pour tous les canaux de réception (45), il est prévu un comparateur (35) commun - et de préférence un circuit de blocage (31) commun et/ou un amplificateur de récupération (33) commun.

8. Capteur optoélectronique, en particulier grille lumineuse,
comportant un émetteur ou une multitude d'émetteurs pour émettre de la lumière d'émission,
comportant en outre un récepteur (11), de préférence une multitude de récepteurs (11) pour recevoir de la lumière d'émission et pour fournir un signal de réception correspondant,
comportant un circuit d'évaluation selon l'une des revendications précédentes.

9. Procédé de traitement d'un signal de réception différentiel d'un capteur optoélectronique, en particulier d'une grille lumineuse, dans lequel le signal de réception est amplifié au moyen d'un amplificateur différentiel (19) qui fournit à deux sorties des signaux de sortie différentiels,
les deux sorties de l'amplificateur différentiel (19) étant reliées à deux entrées d'un amplificateur de récupération (33) qui engendre un signal de sortie asymétrique, et
un circuit de blocage (31) étant agencé entre l'amplificateur différentiel (19) et l'amplificateur de récupération (33),
**caractérisé en ce que**
le circuit de blocage (31) présente deux condensateurs de couplage (63) qui sont chacun branchés en série entre une sortie de l'amplificateur différentiel (19) et une entrée de l'amplificateur de récupération (33), et **en ce que** le circuit de blocage (31) branche les entrées de l'amplificateur de récupération (33) à un potentiel de référence (U_{ref}).

10. Procédé selon la revendication 9,
**caractérisé en ce que**
les entrées de l'amplificateur de récupération (33) sont branchées temporairement au potentiel de référence (U_{ref}), en particulier en activant temporairement au moins un commutateur électronique (65, 71) du circuit de blocage (31), et/ou
**en ce que** les entrées de l'amplificateur de récupération (33) sont branchées à potentiel de référence (U_{ref}) commun, et/ou
**en ce que** le potentiel de référence (U_{ref}) est stocké au moyen des condensateurs de couplage (63) du circuit de blocage (31) au moins temporairement au niveau des entrées de l'amplificateur de récupération (33), et/ou
**en ce que** l'amplificateur différentiel (19) est activé avant ou après avoir activé le circuit de blocage (31).

11. Procédé selon l'une des revendications 9 et 10,
**caractérisé en ce que**
avant ou après avoir désactivé le circuit de blocage (31), un récepteur (11) est relié à une entrée de l'amplificateur de récupération (33) - en particulier en mettant en circuit un commutateur électronique (17) associé -, et
**en ce qu'**ensuite, le signal de sortie - en particulier amplifié en récupération - de l'amplificateur différentiel (19) est comparé à une valeur seuil.

12. Procédé selon l'une des revendications 9 à 11,
**caractérisé en ce que**
les signaux de réception respectifs d'un canal de réception parmi plusieurs canaux de réception (45) sont traités de manière successive,
le canal de réception (45) concerné est choisi en particulier en activant un amplificateur différentiel (19) respectif associé, et/ou
en mettant en circuit un commutateur électronique (17, 26) respectif associé.
